(19) Europäisches Patentamt
European Patent Office
Office européen des brevets

(11) **EP 3 907 514 B1**

(12) **FASCICULE DE BREVET EUROPEEN**

(45) Date de publication et mention de la délivrance du brevet:
**24.09.2025 Bulletin 2025/39**

(51) Classification Internationale des Brevets (IPC):
**G01R 31/14** $^{(2006.01)}$     **G01R 31/26** $^{(2020.01)}$
**G01R 31/12** $^{(2020.01)}$

(21) Numéro de dépôt: **21172374.7**

(22) Date de dépôt: **06.05.2021**

(52) Classification Coopérative des Brevets (CPC):
**G01R 31/14; G01R 31/2623;** G01R 31/1227;
G01R 31/129; G01R 31/52; G01R 31/64

(54) **MESURE DE TEMPS AU CLAQUAGE D'ISOLANTS ÉLECTRIQUES**

ZEITMESSUNG BEIM DURCHBRENNEN VON ELEKTRISCHEN ISOLATOREN

MEASUREMENT OF THE BREAKDOWN TIME OF ELECTRICAL INSULATORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.05.2020 FR 2004492**

(43) Date de publication de la demande:
**10.11.2021 Bulletin 2021/45**

(73) Titulaire: **Commissariat à l'Energie Atomique et aux Energies Alternatives**
**75015 Paris (FR)**

(72) Inventeurs:
- **GARROS, Xavier**
  **38054 GRENOBLE CEDEX 09 (FR)**
- **ARABI, Melissa**
  **38100 GRENOBLE (FR)**
- **CLUZEL, Jacques**
  **38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(56) Documents cités:
US-A- 5 420 513

- **GREG SONNENFELD ET AL: "An agile accelerated aging, characterization and scenario simulation system for gate controlled power transistors", AUTOTESTCON, 2008 IEEE, IEEE, PISCATAWAY, NJ, USA, 8 September 2008 (2008-09-08), pages 208 - 215, XP031355031, ISBN: 978-1-4244-2225-8**
- **ROSENBAUM E ET AL: "High-frequency time-dependent breakdown of SiO/sub 2/", IEEE ELECTRON DEVICE LETTERS, IEEE, USA, vol. 12, no. 6, 30 June 1991 (1991-06-30), pages 267 - 269, XP011406141, ISSN: 0741-3106, DOI: 10.1109/55.82056**
- **INANI ET AL: "Accelerated testing for time dependent dielectric breakdown (TDDB) evaluation of embedded DRAM capacitors using tantalum pentoxide", MICROELECTRONICS RELIABILITY : AN INTERNAT. JOURNAL & WORLD ABSTRACTING SERVICE, ELSEVIER SCIENCE LTD, GB, vol. 47, no. 9-11, 20 September 2007 (2007-09-20), pages 1429 - 1433, XP022261115, ISSN: 0026-2714, DOI: 10.1016/ J.MICROREL.2007.07.053**
- **ALAN WADSWORTH: "Fundamentals of Fast Pulsed IV Measurement", 9 February 2014 (2014-02-09), pages 1 - 60, XP055766245, Retrieved from the Internet <URL:https://www. keysight.com/upload/cmc_upload/All/ 9Feb14Slides.pdf> [retrieved on 20210118]**
- **LATIF Z ET AL: "A Study of the Validity of Capacitance-Based Method for Extracting the Effective Channel Length of MOSFET's", IEEE TRANSACTIONS ON ELECTRON DEVICES, IEEE SERVICE CENTER, PISACATAWAY, NJ, US, vol. 44, no. 2, 1 February 1997 (1997-02-01), XP011016067, ISSN: 0018-9383**

## Description

Domaine technique

La présente description concerne, de façon générale, les dispositifs électroniques, et, en particulier, les dispositifs de test de composants électroniques tels que des transistors ou des condensateurs.

Technique antérieure

Certains composants électroniques, tels que des transistors ou des condensateurs, comprennent des diélectriques, c'est-à-dire des couches en matériau diélectrique ou électriquement isolant. Par exemple, dans un transistor à effet de champ, le diélectrique forme une isolation électrique entre une grille et une région de formation d'un canal conducteur. Dans un condensateur, la couche de diélectrique isole électriquement les électrodes du condensateur entre elles.

Un composant comprenant une couche diélectrique peut être utilisé dans un dispositif électronique tel qu'un circuit électronique. En fonctionnement, la couche diélectrique est soumise à une tension entre des conducteurs électriques en contact avec ses faces opposées (faces principales). Plus la durée d'utilisation et/ou la tension entre les faces opposées de la couche diélectrique augmentent, plus le diélectrique risque de claquer, c'est-à-dire qu'un chemin électriquement conducteur risque de se former dans le diélectrique, traversant celui-ci de part en part et reliant les faces opposées. Une fois que le diélectrique a claqué, le composant est hors d'usage, et le dispositif électronique tout entier risque alors d'être hors d'usage. La durée de vie du composant, et donc du dispositif, est ainsi liée à la tension en fonctionnement entre les faces du diélectrique.

Pour augmenter la durée de vie à une tension de fonctionnement donnée, on pourrait être tenté, par exemple, d'augmenter l'épaisseur de la couche diélectrique. Cependant, ceci nuirait aux performances du composant, telles que la tension de seuil du transistor ou la surface du condensateur. Il existe donc un compromis entre la durée de vie et les performances du composant.

L'article "An agile accelerated aging, characterization and scenario simulation system for gate controlled power transistors" de Greg Sonnenfelt et al. publié le 8 septembre 2008 (AUTOTESTCON, 2008, IEEE pages 208-215) - XP031355031, décrit une plateforme de caractérisation de transistors de puissance à grille de commande.

L'article "High-Frequency time-dependent breakdown of SiO/sub 2/", de E. Rosenbaum et al., publié le 30 juin 1991 (IEEE ELECTRON DEVICE LETTERS, vol. 12, no. 6) - XP011406141 est une étude sur le claquage de diélectrique en oxyde de silicium en fonction du temps.

Le document US 5,420,513 décrit un procédé de prédiction de claquage de diélectrique et de durée de vie de diélectrique.

L'article "Accelerated testing for time dependent dielectric breakdown (TDDB) evaluation of embedded DRAM capacitors using tantalum pentoxide" de Inani et al., publié le 20 septembre 2007 (INTERNAT. JOURNAL & WORLD ABSTRACTING SERVICE, ELSEVIER SCIENCE LTD GB, vol. 47, no. 9-11) - XP022261115, décrit des mécanismes de claquage dans le pentoxyde de tantale.

L'article "Fundamentals of Fast Pulsed IV Measurement" de Alan Wadsworth, publié le 9 février 2014 - XP055766245, décrit différentes techniques de test paramétrique.

Résumé de l'invention

Il existe un besoin d'améliorer le compromis entre durée de vie et performances de composants électroniques.

Il existe un besoin de prédire la durée de vie de composants électroniques.

Il existe un besoin de disposer d'un dispositif de test, permettant de tester des composants électroniques de manière à pouvoir prédire leur durée de vie.

Un mode de réalisation prévoit de pallier tout ou partie des inconvénients des dispositifs connus de test de composants électroniques.

Un mode de réalisation prévoit de pallier tout ou partie des inconvénients des procédés connus de test de composants électroniques.

Un mode de réalisation prévoit de pallier tout ou partie des inconvénients des procédés de prédiction de la durée de vie de composants électroniques.

La présente invention est définie par les revendications annexées

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de manière schématique, un exemple d'un mode de réalisation d'un dispositif de test, et des composants électroniques testés par le dispositif de test ;

la figure 2 représente, de manière schématique, un exemple d'un mode de réalisation d'un circuit du dispositif de la figure 1 ;

la figure 3 représente, de manière schématique, deux exemples d'allure d'une tension du circuit de la figure 2 en fonctionnement ;

la figure 4 représente, de manière schématique, un exemple d'un mode de réalisation d'une partie du dispositif de la figure 1 ;

la figure 5 représente, de manière schématique, un exemple d'un mode de réalisation d'une pointe de test du dispositif de la figure 1 ;

la figure 6 représente, de manière schématique, un exemple d'un mode de réalisation d'une autre partie du dispositif de la figure 1 ;

la figure 7 représente, de manière schématique, des allures en fonction du temps de courants mesurés au cours de tests mis en œuvre par le dispositif de la figure 1 ;

la figure 8 est un diagramme représentant des résultats de tests de plusieurs transistors, obtenus par un dispositif tel que le dispositif de la figure 1 ;

la figure 9 représente un exemple d'allure de durée de vie évaluée de composants en fonction de la valeur d'une tension V appliquée aux composant ;

la figure 10A représente un exemple d'un mode de réalisation d'un composant électronique destiné à être testé par le dispositif de la figure 1 ;

la figure 10B représente un exemple d'un autre mode de réalisation d'un composant électronique destiné à être testé par le dispositif de la figure 1 ;

la figure 10C représente un exemple d'encore un autre mode de réalisation d'un composant électronique destiné à être testé par le dispositif de la figure 1 ; et

la figure 10D représente un exemple d'encore un autre mode de réalisation d'un composant électronique destiné à être testé par le dispositif de la figure 1.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, un générateur d'un signal présentant alternativement des fronts montants et descendants n'est pas décrit en détail, les modes de réalisation décrits étant compatibles avec de tels générateurs usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

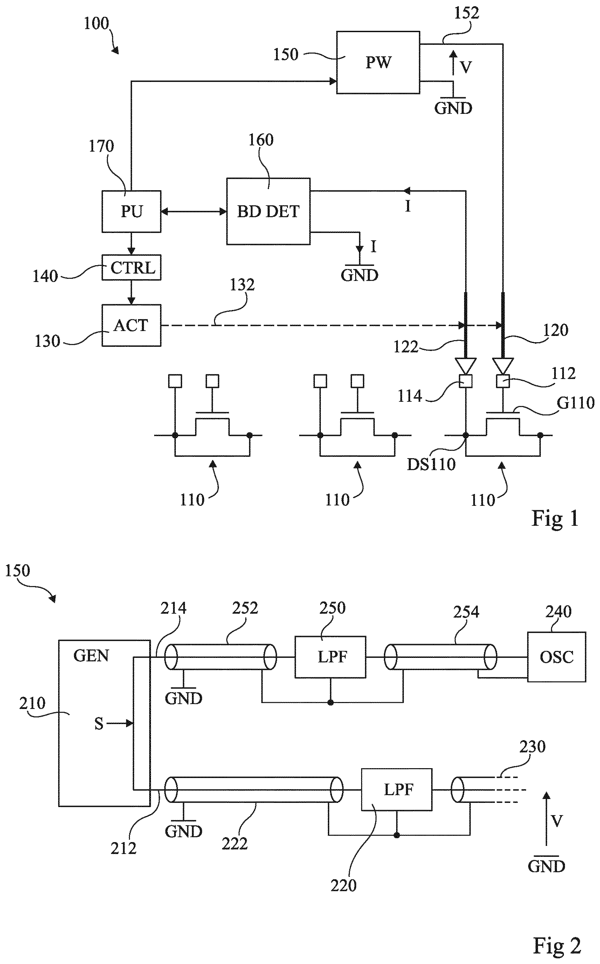

La figure 1 représente, de manière schématique, un exemple d'un mode de réalisation d'un dispositif de test 100 et plusieurs composants 110 testés par le dispositif de test 100. Dans cet exemple, trois composants 110 sont testés, cependant, le nombre de composants peut également être différent de trois, par exemple égal à un, de préférence supérieur à 10, plus préférentiellement supérieur à 30.

Dans cet exemple, les composants 110 sont des transistors, plus particulièrement des transistors à effet de champ. Chaque transistor a une borne de grille G110 et une borne de conduction DS110, aussi appelée borne de drain/source DS110. Par borne de conduction, on entend des bornes que le transistor connecte électriquement entre elles lorsqu'il est à un état passant, et isole électriquement entre elles lorsqu'il est à un état bloqué. Plus précisément, comme mentionné en préambule, le transistor comprend, entre sa grille et une région de formation d'un canal conducteur, une couche diélectrique susceptible de claquer. Les états passant et bloqué sont définis ci-dessus lorsque la couche diélectrique est intègre (non claquée). Lorsque la couche diélectrique est claquée, un chemin conducteur dans la couche diélectrique peut relier les bornes de conduction indépendamment de l'état passant/bloqué du transistor.

La borne de grille G110 est constituée par, ou est connectée à, la grille du transistor. La grille du transistor est en contact avec une face de la couche diélectrique de grille du transistor 110. Lorsqu'un canal de conduction est formé dans le transistor (à l'état passant du transistor), la borne de conduction DS110 est connectée électriquement au canal de conduction, ce canal étant en contact avec l'autre face du diélectrique de grille.

Selon d'autres exemples, les composants 110 sont des condensateurs. Dans ces autres exemples, on remplace chaque transistor 110 et ses bornes G110 et DS110, respectivement par un condensateur et ses bornes ou électrodes.

De préférence, les composants 110 sont d'un même lot de composants identiques. Par identiques, on entend identiques à des tolérances près liées à la précision du procédé de fabrication. Les composants 110 peuvent aussi être de plusieurs lots différents se distinguant l'un de l'autre par un ou plusieurs paramètres, tels que des épaisseurs de la couche diélectrique ou des paramètres du procédé de fabrication.

De préférence, les composants 110 sont similaires ou identiques à des composants utilisés dans un dispositif électronique tel qu'un circuit numérique (non représenté). Par exemple, les transistors 110 ont des mêmes compositions et épaisseurs de leur couche diélectrique (dite aussi isolant de grille) que des transistors utilisés dans le circuit numérique. En fonctionnement, le circuit numérique est configuré pour appliquer, aux composants du même type que les composants 110, des tensions d'utilisation des composants. Ces tensions d'utilisation sont, par exemple, constituées par des signaux numériques appliqués entre grille et source et/ou entre grille et drain des transistors.

Le dispositif de test 100 est extérieur aux composants 110, c'est-à-dire que le dispositif de test 100 et les composants 110 ne sont pas reliés mécaniquement l'un à l'autre de manière permanente. Autrement dit, les composants 110, une fois testés, peuvent être remplacés par d'autres composants 110.

Le dispositif de test 100 est configuré pour être connecté à un composant 110 puis déconnecté de ce composant 110. Ainsi, pour chacun des composants 110, l'un après l'autre, le dispositif 100 est connecté au composant 110 puis déconnecté de ce composant. Plus particulièrement, en fonctionnement, le dispositif 100 teste les composants 110 de manière successive, chaque test étant précédé de la mise en connexion du dispositif de test 100 au composant 110 considéré, et suivi de la déconnexion entre le dispositif de test 100 et le composant 110 considéré.

Pour cela, chaque composant 110 comprend au moins deux plots de connexion 112, 114. Les plots 112, 114 sont prévus pour être connectés électriquement au dispositif de test 100 de manière temporaire, c'est-à-dire uniquement pour la durée du test du composant. Par plot de connexion d'un composant, on entend tout élément conducteur du composant qui est accessible de l'extérieur du composant pour réaliser une connexion temporaire entre le plot de connexion électrique et un dispositif extérieur au composant, par exemple le dispositif de test 100.

Dans l'exemple représenté, le plot de connexion 112 de chaque transistor 110 est relié, de préférence connecté, à la borne de grille G110 du transistor 110, et le plot de connexion 114 est relié, de préférence connecté, à la borne de conduction DS110 du transistor 110.

De préférence, le dispositif de test 100 comprend deux pointes de test 120 et 122, ou pointes de touche, ou encore pointes de contact. Les pointes de test 120 et 122 sont destinées à former un contact temporaire avec les plots respectifs 112 et 114 de chacun des composants 110 successifs. Entre deux tests consécutifs, les pointes de test 120 et 122 sont déconnectées des plots respectifs 112 et 114 du composant 110 testé antérieurement, puis sont mises en contact avec les plots respectifs 112 et 114 du composant 110 testé postérieurement.

Selon un mode de réalisation représenté, les pointes sont mises en contact avec les plots successifs par un actionneur électromécanique 130 (ACT). L'actionneur électromécanique 130 peut alors être commandé par une unité de commande 140 (CTRL) du dispositif de test 100. L'unité de commande 140 peut comprendre un microprocesseur et une mémoire comprenant un programme exécutable par le microprocesseur. L'unité de commande 140 peut comprendre un ordinateur ou un ensemble d'ordinateurs. L'exécution du programme par le microprocesseur provoque, lorsque le test de l'un des composants 110 est terminé, la déconnexion, par l'actionneur 130, entre les pointes de test 120 et 122 et ce composant 110, suivie de la mise en contact, par l'actionneur 130, des pointes de test 120 et 122 avec les plots 112 et 114 d'un autre des composants 110. Dans l'exemple représenté, l'actionneur 130 a un lien mécanique 132 avec les pointes, les composants 110 sont fixes et l'actionneur 130 déplace les pointes. Dans un autre exemple, les pointes sont fixes et l'actionneur 130 déplace les composants 110.

Selon un autre mode de réalisation, les pointes de test 120, 122 sont mises en contact avec les plots des composants successifs par un opérateur. Lorsque le test de l'un des composants 110 est terminé, l'opérateur déconnecte de ce composant 110 les pointes de test 120 et 122, puis met les pointes de test 120 et 122 en contact avec les plots 112 et 114 d'un autre des composants 110.

Bien que l'on ait décrit ci-dessus les deux pointes de test 120 et 122 et les deux plots de connexion 112 et 114, les modes de réalisation ne se limitent pas à deux pointes de test et deux plots de connexion. Ainsi, selon un mode de réalisation, le dispositif de test 100 comprend une seule pointe de test destinée à être connectée à un plot de chaque composant 110. Par exemple, cette seule pointe est la pointe 120 destinée à être connectée successivement aux bornes de grille G110 des transistors 110. La pointe 122 peut alors être remplacée par tout moyen de connexion temporaire d'une borne d'un composant à un dispositif extérieur au composant, c'est-à-dire par tout nœud du dispositif destiné à être connecté à une des bornes du composant et déconnecté de cette borne.

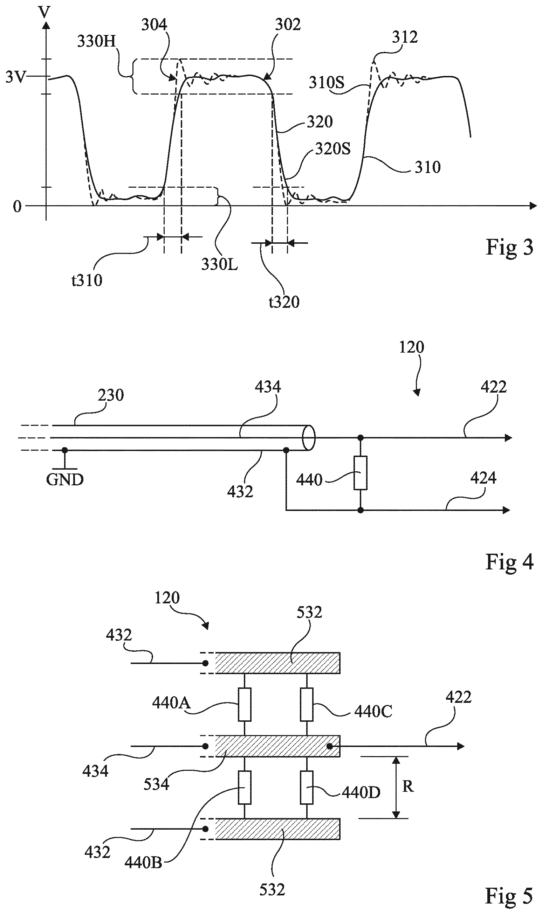

Le dispositif de test 100 comprend un module 150 (PW) fournissant une tension V entre un nœud GND et une sortie 152 du module 150. Le nœud GND est un nœud d'application d'un potentiel de référence, tel que la masse. La sortie 152 est reliée, de préférence connectée, à la pointe de test 120. La tension V fournie par le module 150 est décrite ci-après en relation avec la figure 3.

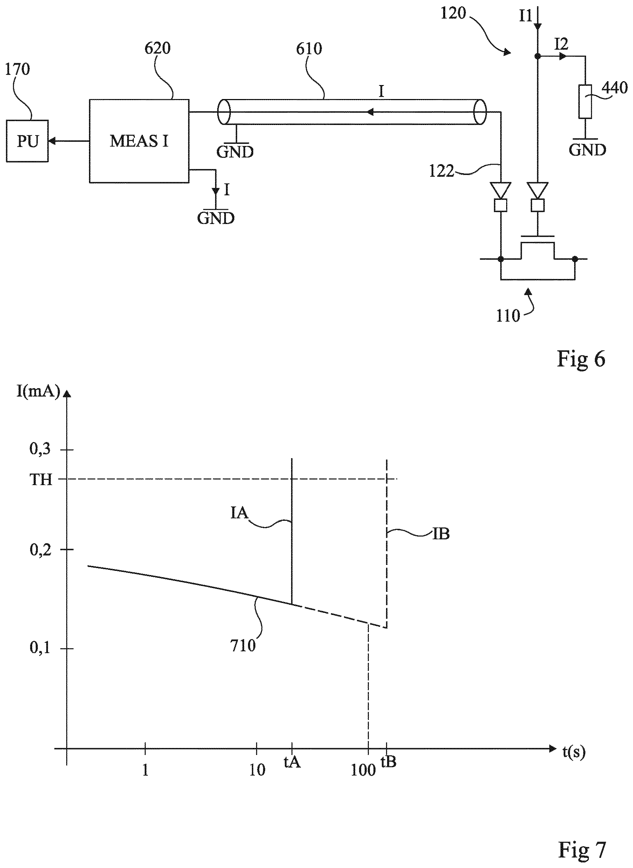

Le dispositif de test 100 comprend en outre un détecteur de claquage 160 (BD DET) du diélectrique de grille. De préférence, le détecteur de claquage 160 relie la pointe 122 au nœud GND. Le claquage est détecté à partir d'un courant I circulant de la pointe 122 au nœud GND. Le détecteur 160 peut comprendre un ampèremètre. Un exemple de fonctionnement du détecteur 160 est décrit ci-après en relation avec la figure 7.

En fonctionnement, la tension V est appliquée, par les pointes de test 120 et 122, entre la borne de source G110 et la borne de conduction DS110. Les pointes 120 et 122 sont connectées respectivement à des conducteurs (respectivement la grille et le canal de conduction du transistor 110 dans l'exemple représenté) en contact avec des faces opposées de la couche diélectrique. Avant claquage, la couche diélectrique isole électriquement les pointes 120 et 122 entre elles, et le courant I est relativement faible. Après claquage, le courant I passe par un chemin conducteur dans le diélectrique claqué, et le courant I est relativement élevé.

De préférence, le détecteur 160 est relié ou connecté à une unité de traitement 170 (PU). L'unité de traitement 170 peut comprendre un microprocesseur et une mémoire comprenant un programme exécutable par le microprocesseur. L'unité de traitement 170 peut comprendre un ordinateur ou un ensemble d'ordinateurs. L'unité de traitement 170 peut être reliée au module 150. Dans l'exemple où le dispositif comprend l'unité de commande 140, l'unité de traitement 170 peut être reliée à l'unité de commande 140, ou, par exemple, l'unité de traitement 170 et l'unité de commande 140 peuvent être confondues, c'est-à-dire constituées par une même unité comprenant un microprocesseur.

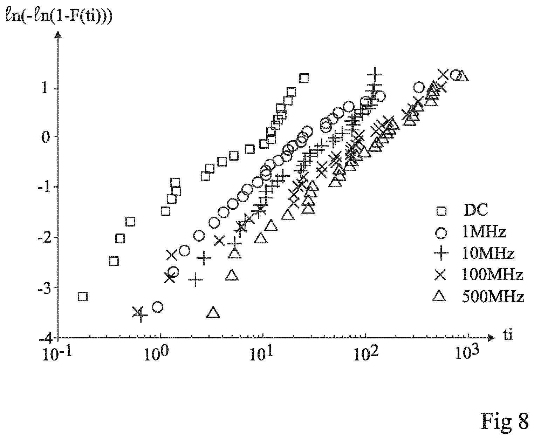

De préférence, l'exécution du programme de l'unité de traitement 170 par le microprocesseur de l'unité de traitement 170 provoque la mise en œuvre d'un procédé de test des composants 110. Le procédé peut comprendre la mesure de la durée de vie des composants testés. La mesure de la durée de vie des composants testés peut permettre la prédiction de la durée de vie de composants du même type que les composants testés. Un exemple d'un mode de réalisation d'un tel procédé est décrit ci-après en relation avec la figure 8. En particulier, l'unité de traitement 170 mesure, pour chaque composant 110 testé, la durée d'application de la tension V jusqu'au claquage du composant 110.

La figure 2 représente, de manière schématique, un exemple d'un mode de réalisation du module 150 du dispositif de la figure 1.

Le module 150 comprend un générateur de pulses 210 (GEN). Le générateur de pulses génère un signal S. Un exemple du signal S est décrit ci-après en relation avec la figure 3. Le générateur 210 fournit le signal S sur une sortie 212 du générateur 210. De préférence, le générateur 210 fournit également le signal S sur une autre sortie 214 du générateur 210. A titre d'exemple, le générateur 210 est du type connu sous le nom commercial "Active Technologies Pulse rider PG-1000".

De préférence, le module 150 comprend un filtre passe-bas 220 (LPF). Le filtre passe-bas 220 a une entrée connectée, de préférence par un câble coaxial 222, à la sortie 212 du générateur 210. Le câble coaxial 222 a son blindage connecté au nœud GND, par exemple du côté du générateur 210. Le filtre passe-bas 220 est, de préférence, référencé par rapport au potentiel du nœud GND, et, plus préférentiellement, est enveloppé dans une enveloppe conductrice reliée ou connectée au blindage du câble coaxial 222. Le filtre passe-bas 220 a une sortie constituant la sortie 152 (figure 1) du module 150. De préférence, la sortie 152 est prévue pour la connexion d'un câble coaxial 230 dont le blindage est connecté à celui du câble coaxial 222.

De préférence, le filtre passe-bas 220 a un temps de réponse à un échelon de Dirac compris entre 50 ps et 300 ps, plus préférentiellement égal à environ 150 ps.

De préférence, le module 150 comprend un oscilloscope 240 (OSC) relié, de préférence par un filtre passe-bas 250 (LPF), à la sortie 214 du générateur 210. Le filtre passe-bas 250 peut être du même type que le filtre passe-bas 220, de préférence, les filtres passe-bas 220 et 250 sont identiques, à des tolérances de fabrication près. L'oscilloscope 240 permet de vérifier la tension V produite par le module 150.

Le filtre passe-bas 250 a une entrée connectée, de préférence par un câble coaxial 252, à la sortie 214 du générateur 210. Le câble coaxial 252 a, par exemple, son blindage connecté au nœud GND, par exemple du côté du générateur 210. Le filtre passe-bas 250 est, de préférence, référencé par rapport au potentiel du nœud GND, et, plus préférentiellement, est enveloppé dans une enveloppe conductrice reliée ou connectée au blindage du câble coaxial 252. Le filtre passe-bas 250 a une sortie connectée, de préférence par un câble coaxial 254, à l'oscilloscope 240. Le blindage du câble coaxial 254 est, de préférence, connecté au blindage du câble coaxial 252.

La figure 3 représente, de manière schématique, deux exemples d'allures de la tension V fournie par le module 150 de la figure 2. Plus précisément :

- une courbe 302 représente la tension V dans le cas préféré où le module 150 comprend le filtre passe-bas 250 ; et

- une courbe 304 en pointillés représente la tension V dans une variante dans laquelle le filtre passe-bas 220 et le câble 222 sont omis, le câble 230 étant connecté à la sortie 212 du générateur 210 (autrement dit, la sortie 212, figure 2, du générateur 210 constitue la sortie 152 du module 150).

La tension V varie sensiblement en créneaux, c'est-à-dire que la tension V est approximativement rectangulaire ou, de préférence, carrée. Plus précisément, une valeur basse et une valeur haute sont définies pour la tension V. Les valeurs, basse et haute, sont respectivement, dans l'exemple représenté, de 0 et 3 V. La tension V prend alternativement un niveau haut et un niveau bas, de manière répétée.

Le niveau haut est défini par un intervalle 330H de valeurs de tension égales à la valeur haute, à 30 % près, de préférence à 20 % près, plus préférentiellement à 10 % près, encore plus préférentiellement à 5 % près. Autrement dit, lorsque la tension V est au niveau haut, sa valeur est située dans l'intervalle 330H.

Le niveau bas est défini par un intervalle 330L de valeurs de tension égales à la valeur basse, à 25 % de la valeur haute près, de préférence à 15 % de la valeur haute près, plus préférentiellement à 10 % de la valeur haute près, encore plus préférentiellement à 5 % de la valeur haute près. Autrement dit, lorsque la tension V est au niveau bas, sa valeur est située dans un intervalle 330L.

La tension V passe du niveau bas au niveau haut, au cours de fronts montants 310, en une durée t310 inférieure à 15%, de préférence inférieure à 10 %, plus préférentiellement inférieure à 5 %, du temps de cycle ou durée de période, de la tension V. La durée t310 sépare l'un de l'autre un instant où la valeur de la tension V sort de l'intervalle 330L et un instant où la valeur de la tension V entre dans l'intervalle 330H.

La tension V passe du niveau haut au niveau bas, au cours de fronts descendants 320, en une durée t320 inférieure à 15%, de préférence inférieure à 10 %, plus préférentiellement inférieure à 5 %, du temps de cycle de la tension V. Le temps t320 sépare un instant où la valeur de la tension V sort de l'intervalle 330H et un instant où la valeur de la tension V entre dans l'intervalle 330L.

Au cours des tests des composants 110, la tension V a, au moins temporairement, une valeur de fréquence élevée, c'est-à-dire supérieure à 10 MHz, de préférence, supérieure à 100 MHz, par exemple égale à 500 MHz.

On aurait pu penser tester le composant 110 en lui appliquant une tension variable différente d'une tension sensiblement en créneaux. On aurait aussi pu penser tester le composant 110 en lui appliquant uniquement une tension continue ou dont les valeurs de fréquence restent toujours inférieures aux valeurs élevées définies ci-dessus. En comparaison, selon les modes de réalisation décrits, du fait que la tension V appliquée au composant 110 est sensiblement en créneaux et a une fréquence élevée, la tension V représente mieux une tension appliquée en fonctionnement à un autre composant similaire au composant 110 et utilisé dans un circuit numérique, en particulier lorsque le circuit numérique a des valeurs élevées de fréquence en fonctionnement. Le test permet donc d'améliorer la précision de l'estimation de la durée de vie du composant dans le circuit numérique.

Dans la variante dans laquelle le filtre passe bas est omis (courbe 304), la tension V présente alternativement des fronts montants 310S et des fronts descendants 320S. Dans cette variante, après chaque front montant 310S, la tension V passe typiquement par un maximum 312 avant de se stabiliser sensiblement à la valeur haute. Ainsi, par rapport à cette variante, la prévision du filtre passe-bas 220 permet d'éviter le passage de la tension V par un maximum, ou permet de réduire l'écart entre ce maximum et la valeur haute.

A titre d'exemple, la prévision du filtre passe bas permet d'obtenir que, en dehors des fronts 310 et 320 :

la tension V au niveau haut reste égale à la valeur haute à moins de 10 % près, par exemple à 5 %; et la tension V au niveau bas reste égale à la valeur basse à moins de 10 % près, par exemple à 5 % près, de la valeur haute. La tension V est donc plus proche d'un signal en créneaux lorsque le filtre 220 est prévu, que lorsque le filtre 220 est omis. Il en résulte que les conditions de test représentent mieux des conditions de fonctionnement d'un composant dans un circuit numérique. En particulier, on évite que la présence du maximum 312 provoque un claquage prématuré du composant 110, d'où il résulterait une sous-estimation de la durée de vie du composant dans le circuit numérique.

De préférence, la tension V présente une forme sensiblement carrée, c'est-à-dire que les durées des niveaux bas et haut est sensiblement égale, de préférence égale. Ceci permet de rapprocher davantage la tension appliquée en cours de test de valeurs représentatives de la tension appliquée en fonctionnement dans un circuit numérique.

L'exemple représenté des valeurs haute et basse (0 et 3 V) de la tension V n'est pas limitatif. De préférence, la valeur basse de la tension V est égale à 0 V ou à environ 0 V (à 10% près, plus préférentiellement à 5 % près, de la valeur haute), et la valeur haute de la tension V peut être toute valeur positive. Par rapport à des variantes dans lesquelles la valeur haute de la tension V n'est pas sensiblement nulle, la prévision d'une tension nulle on sensiblement nulle permet à la tension V de mieux représenter de la tension appliquée en fonctionnement dans un circuit numérique.

Le fait que les valeurs du signal V soient positives permet, par rapport à des valeurs négatives, de former un canal conducteur lorsque le composant est, comme dans l'exemple représenté, un transistor à effet de champ à canal N. Dans un autre exemple, les signes de la tension V peuvent être permutés par rapport à l'exemple représenté, le terme de valeur haute s'entendant alors en valeur absolue. On peut alors, par exemple, former un canal conducteur dans un transistor à effet de champ à canal P. Dans encore d'autres exemples, les valeurs basse et haute sont de signes différents.

De préférence, la valeur haute de la tension V est supérieure à une valeur de tension d'utilisation du composant dans un circuit numérique. La tension V est alors, dans le cas où la valeur basse est nulle ou sensiblement nulle, sensiblement égale à une tension appliquée dans un circuit numérique en fonctionnement, multipliée par un facteur constant strictement supérieur à 1. La valeur haute de la tension V est, de préférence, égale à environ 5 V, par exemple égale à 4,9 V. Cette tension est, en particulier, adaptée à des épaisseurs d'isolant de grille comprises entre 0,5 nm et 5 nm.

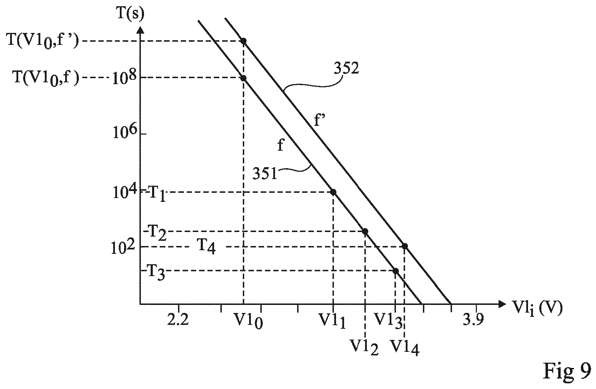

Dans une variante, le facteur constant est, par exemple, égal à 1, autrement dit, la tension V est sensiblement égale à la tension appliquée dans le circuit numérique en fonctionnement. Cependant, par rapport à une telle variante, le facteur constant supérieur à 1 permet d'accélérer le test. A partir du facteur constant et de la durée d'application de la tension V jusqu'au claquage du composant 110 (c'est-à-dire la durée mesurée par le test), on peut calculer la durée d'application d'une tension, dans un circuit numérique, jusqu'au claquage d'un composant, utilisé dans ce circuit, similaire au composant 110. Autrement dit, le résultat de ce calcul est une estimation de la durée de vie du composant dans le circuit. Ce calcul peut être basé sur un calcul usuel de durée de vie dans un circuit à partir de résultats de tests accélérés. Ce calcul peut également être effectué de la manière décrite ci-après en relation avec la figure 9 ci-après.

De préférence, le dispositif de test comprend un régulateur de température (non représenté), configuré pour maintenir, pendant le test, une température du composant égale à une température prédéfinie, par exemple égale à 25°C. La température prédéfinie peut être une température maximale d'utilisation du circuit numérique comprenant le composant testé. La température prédéfinie peut être de 125°C, ou, en particulier dans le cas d'une application automobile, de 150°C.

De préférence, à partir de la durée de vie des composants estimée de la manière décrite ci-dessus, on estime la durée de vie du circuit numérique comprenant ces composants de manière usuelle à partir du nombre de composants dans le circuit et/ou de la surface du circuit.

La figure 4 représente, de manière schématique, un exemple d'un mode de réalisation de la pointe de test 120 du dispositif de la figure 1. Selon ce mode de réalisation, la pointe de test 120 est connectée, par le câble coaxial 230 (figure 2), à la sortie 152 du module 150 de fourniture de la tension V. Le câble coaxial 230 a, de préférence, son blindage 432 relié, plus préférentiellement connecté, au nœud GND. Le câble coaxial 230 transmet la tension V entre l'âme 434 du câble 230 et le blindage 432 du câble 230.

Le câble coaxial 230 présente une impédance, c'est-à-dire une impédance caractéristique ou impédance de transmission, de préférence égale à 50 Ω. Plus préférentiellement, l'impédance des câbles coaxiaux 222 (figure 2) et/ou 230 est adaptée au générateur 210 (figure 2).

La pointe de test 120 comprend un élément de contact 422 avec un plot du composant à tester (plot 112, figure 1). L'élément de contact 422 est relié, de préférence connecté, à l'âme 434 du câble 230.

Selon le présent mode de réalisation, la pointe 120 comprend un élément résistif 440 reliant l'âme 434 du câble 230 au blindage 432 du câble 230. Par élément résistif, on entend ici tout élément ayant une impédance sensiblement égale, dans une plage de fréquences de la tension V, à celle d'une résistance. De préférence, l'élément résistif 440 comprend, ou est constitué par, une résistance ou plusieurs résistances en série et/ou en parallèle. De préférence, l'élément résistif 440 a une borne connectée électriquement à l'âme 434 et une autre borne connectée électriquement au blindage 432.

De préférence, l'élément résistif 440 a une valeur de résistance sensiblement égale à, plus préférentiellement égale à, l'impédance du câble 230. Ainsi, la valeur de l'élément résistif 440 est égale à environ 50 Ω, de préférence égale à 50 Ω. Ceci permet à la tension V d'être plus proche d'une tension en créneaux que lorsque l'élément résistif est omis. Il en résulte une estimation plus précise de la durée de vie d'un composant dans un circuit numérique.

Selon un mode de réalisation, la pointe de test 120 comprend un autre élément de contact 424 relié, de préférence connecté, au blindage 432 du câble 230. L'élément de contact 424 est destiné à être mis en contact, par exemple, avec un nœud d'application d'un potentiel de référence du composant 110 (figure 1) à tester, par exemple une masse du composant 110 ou de plusieurs des composants 110. Selon d'autres modes de réalisation, la masse du ou des composants 110 peut être reliée au nœud GND de toute manière usuelle de connecter des masses d'un ou plusieurs composants à tester et d'un dispositif de test.

La figure 5 représente, de manière schématique, un exemple d'un mode de réalisation de la pointe de test de la figure 4.

La pointe de test 120 comprend un conducteur électrique 532 connecté au blindage 432 du câble 230 (figure 4). Le conducteur électrique 532 entoure un conducteur central 534 connecté à l'âme 434 du câble 230.

L'élément résistif 440 est constitué de plusieurs résistances disposées électriquement en parallèle entre les conducteurs électriques 534 et 532. Dans l'exemple représenté, l'élément résistif est constitué de quatre résistances 440A, 440B, 440C et 440D. Ainsi, chaque résistance 440A, 440B, 440C et 440D a une valeur quadruple de celle de l'élément résistif 440. Les valeurs des résistances sont ainsi, de préférence, égales à environ 200 Ω, plus préférentiellement égales à 200 Ω.

De préférence, les résistances 440A, 440B, 440C et 440D sont réparties autour de la pointe de test entre les conducteurs 532 et 534. Plus préférentiellement, la répartition est régulière. Dans l'exemple représenté, la répartition régulière correspond aux quatre résistances 440A, 440B, 440C et 440D situées dans le plan de la figure 4, deux des résistances (440A et 440C) étant situées d'un côté du conducteur central 534 et deux autres des résistances (440B et 440D) étant située de l'autre côté du conducteur central 534. Dans un autre exemple, les résistances sont situées à des positions séparées d'environ 90° degrés autour du conducteur central 534.

Selon un avantage, le fait de prévoir de former l'élément résistif 440 par plusieurs résistances, de préférence quatre résistances, permet, pour une tension V donnée, de réduire la puissance de chaque résistance 440A, 440B, 440C, 440D. Par puissance d'une résistance, on entend une valeur de puissance en deçà de laquelle la résistance peut dissiper la puissance sans subir de dégradation ni de variation de sa valeur au-delà de ses limites de tolérance. Le volume occupé par les quatre résistances 440A, 440B, 440C, 440D est alors inférieur au volume qui serait occupé par une seule résistance de puissance quatre fois plus élevée que celle des résistances 440A, 440B, 440C, 440D, ce qui permet de réduire l'encombrement de la pointe 120 et/ou de faciliter l'intégration des résistances 440A, 440B, 440C, 440D entre les conducteurs 534 et 532. A titre d'exemple, les conducteurs 534 et 532 sont séparés radialement par une distance R comprise entre 0,5 mm et 2 mm.

A titre d'exemple, chaque résistance 440A, 440B, 440C, 440D a une puissance égale à environ 30 mW, de préférence égale à 30 mW. Cette valeur de puissance de 30 mW permet de dissiper la puissance thermique produite dans chaque résistance 440A, 440B, 440C, 440D lorsque la tension V est sensiblement carrée des valeurs basse et haute égales à, respectivement, 0 et 5 V, et permet aussi, en même temps, que les résistances soient particulièrement faciles à intégrer entre les conducteurs 534 et 532.

Bien que, dans l'exemple décrit ci-dessus en relation avec la figure 5, l'élément résistif 440 est constitué de quatre résistances, on peut prévoir plus ou moins de quatre résistances, par exemple, deux, trois, cinq ou six résistances, de préférence réparties autour du conducteur 534. Le calcul des valeurs des résistances et de leurs puissances est à la portée de la personne du métier.

La figure 6 représente, de manière schématique, un exemple d'un mode de réalisation d'un détecteur de claquage compris dans le dispositif de la figure 1. On a également représenté un composant 110 testé, ainsi que la pointe 120 comprenant l'élément résistif 440.

Dans l'exemple représenté, la pointe 122 est connectée, par un câble coaxial 610, à un capteur de courant 620 (MEAS I), par exemple un ampèremètre. Le câble 610 a, de préférence, son blindage connecté au nœud GND, au moins du côté du capteur 620.

A titre d'exemple, le capteur de courant 620 est du type connu sous la marque commerciale "Keysight B1500".

Le capteur 620 fournit une valeur du courant I à l'unité de traitement 170. L'unité de traitement 170 est alors programmée pour détecter le claquage du composant 110 à partir de la valeur mesurée du courant I, de la manière décrite ci-après avec la figure 7. Le capteur 620 et l'unité de traitement 170 forment ainsi un détecteur de claquage jouant ensemble le même rôle que le détecteur de claquage 160 (figure 1). Ce détecteur de claquage peut être remplacé par tout détecteur de claquage, tel que le détecteur 160 (figure 1), qui met en œuvre la détection à partir d'une mesure du courant I et fournit le résultat de cette détection à l'unité 170.

De préférence, le claquage est détecté à partir du courant I circulant entre la pointe 122 et le nœud GND. Autrement dit, la tension V est appliquée entre la pointe 120, connectée à une première face du diélectrique (face principale de la couche diélectrique), et le nœud GND, et le détecteur de claquage relie au nœud GND la pointe 122 connectée à une deuxième face du diélectrique opposée la première face.

Dans une variante, on mesure le courant en positionnant le capteur 620 entre le module 150 (figure 1) de fourniture de la tension V et la pointe de test 120. Le capteur 620 mesure alors un courant I1. Le courant I1 comprend le courant I circulant entre la pointe 122 et le nœud GND et un courant I2 s'écoulant par l'élément résistif 440 vers le nœud GND. Par rapport à cette variante, la détection du claquage à partir du courant I circulant entre la pointe 122 et le nœud GND permet que le courant mesuré I, contrairement au courant I1, ne comprenne pas le courant I2. La distinction entre valeurs de courant mesurées avant et après le claquage est facilitée. Ainsi, la détection du claquage du composant est facilitée.

La figure 7 représente, de manière schématique, l'allure en fonction du temps t(s) de courants mesurés au cours d'un test mis en œuvre par le dispositif de test 100 de la figure 1. Plus précisément, on a représenté le courant I(mA) au cours du test de deux composants 110. La courant I prend des valeurs IA pour l'un des composants et à des valeurs IB pour l'autre des composants. Le temps est représenté en échelle logarithmique, les valeurs 1, 10 et 100 s étant disposées régulièrement.

Avant le claquage, les valeurs IA et IB pour les composants suivent sensiblement une même courbe 710. Dans l'exemple représenté, la courbe 710 est décroissante en fonction du temps. Dans d'autres exemples, les valeurs IA et IB peuvent suivre une courbe croissante en fonction du temps. Les valeurs IA et IB sont alors relativement faibles. A des instants tA et tB, les valeurs respectives IA et IB deviennent relativement élevées.

Pour détecter le claquage du diélectrique du composant 110, le détecteur 160 (figure 1) ou l'unité de traitement 170 (figure 6) compare la valeur mesurée du courant à un seuil TH. Lorsque le diélectrique du composant 110 a claqué, la valeur mesurée est supérieure au seuil TH.

L'exemple de détection de claquage ci-dessus n'est pas limitatif, et les modes de réalisation décrits sont compatibles avec tout procédé de détection d'un claquage de diélectrique auquel une tension est appliquée. En particulier, le claquage peut être détecté par une augmentation rapide du courant mesuré, c'est-à-dire une augmentation d'un facteur supérieur à un seuil donné, de préférence supérieur à 1,5, par exemple supérieur à 100, se produisant en temps inférieur à une durée donnée, par exemple 10 fois inférieure au temps écoulé depuis le début de l'application de la tension V.

La figure 8 représente, sous forme de diagramme de Weibull, un exemple de résultats de tests de plusieurs transistors, obtenus par un mode de réalisation du dispositif de test de la figure 1.

Dans cet exemple, les composants sont des transistors de type semiconducteur sur isolant complètement déserté, FDSOI (en anglais "Fully Depleted Semiconductor On Insulator"), et ont une largeur de grille de 28 nm et une épaisseur d'isolant de grille de l'ordre de 3 nm.

Selon le présent mode de réalisation du dispositif de test, la tension V appliquée au composant testé a une fréquence modulable, ou sélectionnable, dans une plage de fréquences. De préférence, la plage de fréquences s'étend à partir d'une valeur inférieure à 10 MHz, de préférence, inférieure ou égale à 1 Hz ou égale la valeur nulle, jusqu'à une valeur supérieure donnée supérieure à 10 MHz. La valeur supérieure donnée est, de préférence, supérieure ou égale à 500 MHz. Le dispositif de test est configuré pour que la valeur de fréquence de la tension V soit sélectionnable dans toute la plage de fréquences. Dans l'exemple représenté, la fréquence prend les valeurs successives 1 MHz, 10 MHz, 100 MHz et 500 MHz.

Le dispositif de test peut être configuré pour que la tension V puisse être continue en dehors de phases pendant lesquelles la tension est sensiblement en créneaux de la manière décrite ci-dessus. Dans l'exemple représenté, la tension V prend une valeur continue (DC).

De préférence, le dispositif de test est configuré pour que les valeurs haute et basse de la tension V ne varient pas lorsque la fréquence de la tension V varie. De préférence, dans le cas où la tension V est continue, la tension V prend la valeur haute.

Le dispositif de test est configuré pour que, lorsque la fréquence de la tension V, varie, le rapport cyclique de la tension V reste égal à une valeur donnée. Par rapport cyclique, on entend le rapport entre la durée d'un niveau haut de la tension V et le temps de cycle de la tension V. De préférence, le rapport cyclique est égal à 0,5, ce qui correspond à une tension V sensiblement carrée.

De préférence, on utilise le dispositif de test dans un procédé de détermination d'une durée de vie d'un lot de composants identiques.

Le procédé comprend, pour chacune des valeurs successives de la valeur de fréquence de la tension V, le test de plusieurs composants, par exemple de plus de 10 composants, de préférence plus de 30 composants. On obtient alors, pour chacun des composants, des durées ti(s) d'application de la tension V jusqu'au claquage du composant, appelées aussi temps au claquage ti.

De préférence, on place ensuite les résultats sur un digramme de Weibull, tel que celui de l'exemple de la figure 8. Les durées ti sont représentées en échelle logarithmique entre $10^{-1}$ et $10^3$ s sur l'axe des abscisses du diagramme de la figure 8.

Ainsi, pour chacune des valeurs successives de la fréquence de la tension V, on calcule, pour chaque durée ti, une distribution cumulée F(ti) des temps au claquage ti. On calcule alors, en ordonnée, une valeur ln(-ln(1-F(ti))) pour chaque durée ti, la fonction ln() étant le logarithme népérien.

Le procédé comprend ensuite l'obtention des paramètres d'une loi de distribution de Weibull pour chacune des valeurs successives de la fréquence. Ceci peut être obtenu, pour chacune des valeurs successives de la fréquence, par tout procédé usuel d'obtention de paramètres d'une loi de distribution de Weibull à partir d'un diagramme de Weibull, typiquement par une régression linéaire ou, le cas échant, non linéaire.

Les paramètres de la loi de Weibull sont représentatifs de la durée de vie des composants du lot testé. A titre d'exemple, on définit une durée de vie évaluée T correspondant à la durée de vie d'un pourcentage donné, par exemple 63%, des composants testés, c'est-à-dire que la durée de vie évaluée T a la valeur du temps de claquage ti correspondant à une valeur donnée, par exemple zéro, de la valeur ln(-ln(1-F(ti))) représentée en ordonnées. On a ainsi obtenu la durée de vie en fonction de la fréquence de signaux numériques appliqués au composant dans un circuit en fonctionnement.

De préférence, le procédé ci-dessus est répété pour plusieurs lots différents. Les lots ont des paramètres de fabrication différents, tels que, par exemple, l'épaisseur de grille des transistors du lot. Ces paramètres correspondent à des performances différentes des transistors des divers lots. Par exemple les différents lots ont différentes consommations électriques, différentes températures de fonctionnement, etc.

De préférence, pour une fréquence de fonctionnement donnée, on sélectionne un lot parmi les différents lots sur la base des paramètres de la loi de Weibull, par exemple sur la base de la durée de vie évaluée T, de manière à optimiser le compromis entre performance et durée de vie des composants de ce lot pour une utilisation dans un dispositif électronique tel qu'un circuit numérique.

On constate, sur le diagramme de la figure 8, que les composants soumis à des tensions de fréquences plus élevées ont des durées de vie plus élevées. Du fait que la valeur de fréquence est modulable et peut prendre des valeurs élevées telles que définies ci-dessus, la tension V a une fréquence proche de, ou égale à, la fréquence de la tension appliquée dans le circuit numérique en fonctionnement. Ceci est combiné au fait, mentionné précédemment, que la tension V est sensiblement en créneaux représentatifs de la tension appliquée dans le circuit numérique.

Il en résulte que le procédé de sélection de lot décrit ci-dessus évite, par rapport à un procédé utilisant, par exemple, des fréquences restant inférieures à 10 MHz, de sousestimer la durée de vie des composants. On peut alors choisir des composants plus performants, ou moins coûteux. En choisissant des fréquences supérieures temporairement à 10 MHz, on se rapproche, lors des tests, des gammes de fréquences de fonctionnement du composant à tester, ce qui améliore l'estimation de durée de vie du composant testé.

On a ainsi amélioré le compromis entre fiabilité et performance des lots sélectionnés. Ceci peut être particulièrement avantageux dans les cas où le dispositif électronique est destiné à une application automobile, car on évite alors qu'une sous-estimation de la durée de vie amène à rejeter un lot performant et/ou peu cher ayant en pratique une durée de vie suffisante.

Un avantage du dispositif décrit, en particulier par rapport à l'article *"An agile accelerated aging, characterization and scenario simulation system for gate controlled power transistors"* susmentionné, est, outre le choix des fréquences supérieures à 10 MHz qui améliore l'estimation de la durée de vie du composant, que l'on évite le recours à un réseau de commutation (*"Gate Isolation Switching Network"* et "Gate Driver Switching Network", figure 1 de l'article) entre le générateur et la grille du composant à tester. Dans le dispositif visé par la présente description, un tel réseau de commutation ralentirait les mesures notamment en raison des temps de commutation. Les solutions présentées dans la présente description évitent ce besoin grâce notamment au fait que le dispositif est adapté à la nature du composant à tester et que le composant à tester est, s'agissant d'un transistor, lui-même adapté par l'interconnexion de ses drain et source.

On notera également que, dans l'article susmentionné, un filtre passe-bas est utilisé en aval de l'outil de mesure alors que, dans les solutions de la présente description, un filtre passe-bas 250 est présent entre le générateur 210 du module 150 et le composant à tester. Un avantage des modes de réalisation décrit est que les créneaux fournis par le générateur sont alors mieux définis.

Bien que, dans le procédé décrit ci-dessus, le rapport cyclique soit constant, le dispositif de test peut également être configuré pour que le rapport cyclique soit sélectionnable entre 0 et 1. Ainsi, on peut sélectionner plusieurs valeurs de fréquence de la tension V pour plusieurs valeurs du rapport cyclique, ce qui permet de rapprocher davantage la tension V de valeurs représentatives d'une tension appliquée dans un circuit numérique, notamment en fonction des types de signaux numériques appliqués au composant utilisé dans le circuit numérique.

La figure 9 représente des exemples d'allure de la durée de vie évaluée T (en s) de composants d'un même lot, en fonction de valeurs $V1_i$ (par exemple $V1_0$, $V1_1$, $V1_2$, $V1_3$, $V1_4$, exprimées en volts) d'une tension V1 appliquée aux composants. On a représenté des allures 351 et 352 de la durée de vie évaluée T pour une première fréquence f, et pour une deuxième fréquence f' par exemple supérieure à la première fréquence. La durée de vie évaluée T et les valeurs $V1_i$ sont représentées en échelle logarithmique.

Chacune des valeurs $V1_i$ correspond :

-　au cours d'un test accéléré de composants du lot, à la valeur haute de la tension V appliquée pendant un ou plusieurs tests (c'est le cas des valeurs $V1_1$, $V1_2$, $V1_3$, $V1_4$ dans l'exemple représenté) ; ou
-　en fonctionnement dans un circuit numérique, à une valeur haute ($V1_0$ dans l'exemple représenté) de tension appliquée aux composants du lot.
　Les première et deuxième fréquences sont celles de la tension appliquée au cours du test ou dans le circuit numérique.

A partir des durées de vie évaluées en test, on peut obtenir une ou des valeurs de durées de vie estimées des composants du lot dans le circuit numérique en fonctionnement, de la manière décrite ci-après.

Les valeurs hautes $V1_i$ choisies pour effectuer les tests à une même fréquence de la tension V sont séparées l'une de l'autre d'une valeur comprise entre 50 mV et 300 mV, par exemple égale à 200 mV. Ainsi, dans l'exemple représenté, les valeurs hautes $V1_1$, $V1_2$, et $V1_3$ sont utilisées pour des tests effectués à la première fréquence f et sont égales à respectivement 2,8 V, 3,0 V, et 3,2 V.

Pour la première fréquence f, pour chacune des valeurs hautes $V1_i$ concernées (par exemple $V1_1$, $V1_2$ et $V1_3$) on obtient une valeur respective $T_i$ ($T_1$, $T_2$, $T_3$) de la durée de vie T évaluée en test accéléré. Cette valeur $T_i$ peut être obtenue à partir d'une distribution de Weibull de la manière décrite ci-dessus en relation avec la figure 8.

A partir des valeurs hautes $V1_i$ des tests à la première fréquence f, et à partir des valeurs respectives $T_i$ de durée de vie évaluée, on obtient un coefficient A(f) et un exposant p, sur la base d'une loi de puissance donnée par la relation (1) suivante :
[Math 1]

$$T(V1_i, f) = A(f).V1_i^{-p} \qquad (1)$$

où $T(V1_i, f)$ correspond à des valeurs de durée de vie pour les valeurs hautes respectives $V1_i$ des tests à la première fréquence f. Le coefficient A(f) et l'exposant p peuvent être obtenus par un procédé usuel de recherche de meilleur ajustement (en anglais "best fit") entre les valeurs $T_i$ et les valeurs $T(V1_i, f)$. Par exemple, le coefficient A(f) et l'exposant p sont obtenus par une régression linéaire usuelle des logarithmes des valeurs $T_i$ en fonction des logarithmes des valeurs hautes $V1_i$. La relation (1) est illustrée par le fait que, pour chaque fréquence, l'allure 351, 352 de la durée de vie évaluée en fonction des valeurs hautes $V1_i$ correspond à une droite.

Une estimation de la durée de vie $T(V1_0, f')$ dans le circuit numérique peut alors être fournie par la relation (1) dans laquelle les valeurs hautes $V1_i$ sont remplacées par la valeur haute $V1_0$, c'est-à-dire en extrapolant la relation (1) pour la valeur haute $V1_0$.

On peut également, à partir des tests effectués à la première fréquence f, estimer une durée de vie $T(V1_0, f')$ dans un circuit numérique à la deuxième fréquence f'. Pour la deuxième fréquence f' et pour l'une des valeurs hautes $V1_i$ (par exemple la valeur $V1_4$), on obtient une valeur correspondante $T_i$ (par exemple la valeur $T_4$) de la durée de vie T évaluée en test accéléré. On peut alors obtenir une valeur A(f') définie par la relation (2) suivante :
[Math 2]

$$A(f') = T_i . V1_i^p \qquad (2)$$

Une estimation de la durée de vie $T(V1_0, f')$ dans le circuit numérique peut alors être fournie par la relation (1) dans laquelle les valeurs hautes $V1_i$ sont remplacées par la valeur haute V1, et le coefficient A(f) prend la valeur A(f').

On a ainsi obtenu une estimation de la durée de vie à la deuxième fréquence f' à partir des résultats de tests pour la seule valeur haute $V1_4$. Dans une variante, on estime la durée de vie à la deuxième fréquence de la même manière que pour la première fréquence, pour plusieurs valeurs hautes $V1_i$. Par rapport à cette variante, le fait d'utiliser une seule valeur haute $V1_i$ permet d'éviter d'utiliser des valeurs hautes $V1_i$ (par exemple la valeur $V1_1$) pour lesquelles les tests sont longs à effectuer (par exemple de l'ordre de 3 heures pour chaque composant testé dans l'exemple représenté). L'estimation de la durée de vie pour la deuxième fréquence f' est donc plus rapide que pour la première fréquence f.

Ceci est rendu possible par le fait, constaté par les inventeurs, que, pour un même lot, le coefficient p de la relation (1) ne varie sensiblement pas en fonction de la fréquence dans la plage de fréquences concernée. L'exposant p est typiquement compris entre 40 et 60, égal à 51,8 dans l'exemple représenté. A titre d'exemple, le coefficient A(f') est égal à $10^{28,1}$ lorsque les valeurs hautes $V1_i$ sont exprimées en volts et la durée de vie T est exprimée en secondes.

Bien que l'on ait décrit ci-dessus l'obtention de l'exposant p à partir de tests effectués à la première fréquence, l'exposant p peut être obtenu de la manière décrite ci-dessus en remplaçant les tests accélérés dans lesquels la tension appliquée a la première fréquence par des tests accélérés dans lesquels la tension appliquée est continue.

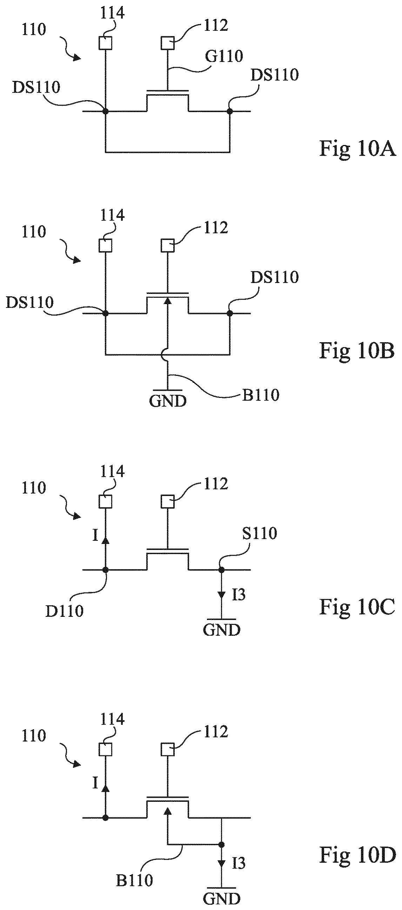

Les figures 10A à 10D représentent des exemples de modes de réalisation de composants électroniques 110 destinés à être testés par le dispositif de la figure 1. Plus précisément, dans ces exemples, les composants électroniques sont des transistors à effet de champs.

Les transistors 110 des figures 10A à 10D sont identiques ou similaires à des transistors usuels utilisés dans des circuits numériques, à des différences près qui, seules, sont décrites ci-après. Les éléments ou paramètres communs, tels que des épaisseurs d'isolant de grille, largeur de grille, etc., ne sont pas décrits en détails. Les transistors 110 ont, de préférence, une borne de conduction DS110, D110, reliée au plot 114, et une borne de grille G110 reliée au plot 112. De préférence, chaque transistor 110 est configuré pour que la tension V entre les plots 112 et 114 soit appliquée uniquement à la grille du transistor 110 considéré, c'est-à-dire qu'aucun autre diélectrique ayant une tension de claquage proche de celle du transistor 110 considéré ne soit en parallèle du diélectrique de grille du transistor 110 considéré.

En figures 10A et 10B, les transistors 110 ont leurs bornes de conduction DS110, leur drain et leur source, reliées ensemble, de préférence interconnectés (directement connectés sans élément intermédiaire autre qu'un conducteur). Plus particulièrement, le transistor de la figure 10A est de type FDSOI, et ne comprend pas de borne reliée à sa zone de formation de canal, dite aussi borne de corps. Le transistor de la figure 10B est un transistor comprenant une borne de corps B110. Le transistor de la figure 10B peut être de type semiconducteur sur isolant, SOI (en anglais "Semiconductor On Insulator") ou, par exemple, de type dit transistor en volume (en anglais "bulk transistor") c'est-à-dire à région de formation de canal constituée par une région dopée d'une tranche (en anglais "wafer") semiconductrice. De préférence, la borne de corps B110 n'est pas connectée aux bornes de conduction DS110. Plus préférentiellement, la borne de corps B110 est reliée, encore plus préférentiellement connectée, au nœud GND pendant le test.

En figures 10C et 10D, la source S110 des transistors 110 est reliée, de préférence connectée, au nœud GND pendant le test. Dans l'exemple de la figure 10C, le transistor 110 est de type FDSOI. Dans l'exemple de la figure 10D, le transistor 110 est du type ayant des bornes de source S110 et de corps B110 reliée entre elles, de préférence connectées entre elles. Dans l'exemple de la figure 10D, le transistor peut être de type SOI ou de type en volume.

Par rapport aux exemples des figures 10C et 10D, les exemples des figures 10A et 10B, dans lesquels les bornes de drain/source sont connectées ensemble et ne sont pas connectées au nœud GND, permettent d'éviter qu'une partie I3 du courant transitant par le diélectrique s'écoule vers le nœud GND. Ainsi, le courant I mesuré pour détecter le claquage est plus proche de celui qui passe par le diélectrique.

En particulier, les inventeurs ont constaté que, lorsque la valeur haute de la tension V est supérieure à une valeur seuil, par exemple de l'ordre de 2V, le courant I3 est supérieur au courant I avant claquage. Pour de telles tensions V, par rapport aux exemples des figures 10C et 10D, les exemples des figures 10A et 10B permettent de faciliter la détection du claquage, en particulier permettent de faciliter le choix de la valeur TH (figure 7) du seuil de courant. En outre, pour de telles tensions V, par rapport aux exemples des figures 10C et 10D, les exemples des figures 10A et 10B permettent, avant claquage, de mesurer le courant I passant dans le diélectrique en fonction de la fréquence de la tension V et/ou en fonction de la durée d'application de la tension V.

Divers modes de réalisation et variantes ont été décrits. La personne du métier comprendra que certaines caractéristiques de ces divers modes de réalisation et variantes pourraient être combinées, et d'autres variantes apparaitront à la personne du métier.

Enfin, la mise en œuvre pratique des modes de réalisation et variantes décrits est à la portée de la personne du métier à partir des indications fonctionnelles données ci-dessus.

**Revendications**

1. Dispositif de test (100) d'au moins un composant électronique (110), comprenant :

   - un module (150) configuré pour fournir une tension (V) sensiblement en créneaux ayant une fréquence prenant, au moins temporairement, une ou des valeurs de fréquence supérieures à 10 MHz ;
   - au moins un nœud d'application de la tension, destiné à être connecté au composant puis déconnecté du composant ; et
   - un détecteur (160) configuré pour détecter un claquage d'un diélectrique du composant.

2. Dispositif selon la revendication 1, dans lequel la fréquence est modulable dans une plage s'étendant de 0 à une valeur supérieure donnée, la valeur supérieure étant de préférence supérieure ou égale à 500 MHz.

3. Dispositif selon la revendication 1 ou 2, comprenant un câble coaxial (222, 230) configuré pour transmettre ladite tension, le câble coaxial ayant une impédance caractéristique, de préférence égale à 50 Ω.

4. Dispositif selon l'une quelconque des revendications 1 à 3, dans lequel ledit au moins un nœud comprend au moins une pointe de test (120) configurée pour appliquer ladite tension auxdits composants (110).

5. Dispositif selon les revendications 3 et 4, dans lequel la pointe (120) comprend un élément résistif (440) de valeur sensiblement égale à l'impédance caractéristique du câble (230), de préférence égale à environ 50 Ω.

6. Dispositif selon la revendication 5, dans lequel l'élément résistif (440) comprend plusieurs, de préférence quatre, résistances (440A, 440B, 440C, 440D) de valeurs égales, et, de préférence :

   - les valeurs desdites résistances sont égales à environ 200 Ω ; et/ou
   - lesdites résistances ont des puissances égales à environ 30 mW.

7. Dispositif selon l'une quelconque des revendications 1 à 6, comprenant un générateur (210) d'un signal (S) présentant alternativement des fronts montants et descendants, et un filtre passe-bas (220) en sortie du générateur, configuré pour fournir ladite tension (V) à partir dudit signal.

8. Dispositif selon la revendication 7, dans lequel le filtre passe-bas a un temps de réponse à un échelon de Dirac compris entre 50 ps et 300 ps, plus préférentiellement égal à environ 150 ps.

9. Dispositif selon l'une quelconque des revendications 1 à 8 :

   - configuré pour que ladite tension (V) soit appliquée entre un premier nœud (120) destiné à être connecté à une première face du diélectrique et un deuxième nœud (GND) d'application d'un potentiel de référence ; et
   - comprenant un détecteur (160 ; 620, 170) d'un courant (I) supérieur à un seuil (TH), reliant le deuxième nœud à un troisième nœud (122) destiné à être connecté à une deuxième face du diélectrique opposée à la première face.

10. Dispositif selon l'une quelconque des revendications 1 à 9, dans lequel ladite tension (V) a un rapport cyclique modulable.

11. Dispositif selon l'une quelconque des revendications 1 à 10, dans lequel les créneaux de ladite tension (V) sont entre une valeur de tension sensiblement nulle et une valeur de tension donnée, la valeur de tension donnée étant, de préférence, supérieure à une valeur de tension maximale d'utilisation du composant.

**12.** Procédé de test de plusieurs composants électroniques (110), comprenant la mise en œuvre d'un dispositif (100) selon les revendications 1 à 11.

**13.** Procédé selon la revendication 12, comprenant, pour chacune de plusieurs desdites valeurs de fréquence, des étapes consistant à :

- pour chaque composant l'un après l'autre, appliquer ladite tension au composant et mesurer une durée (tA, tB) d'application de ladite tension (V) jusqu'à détection d'un claquage du composant par le détecteur (160) ; et
- déduire desdites durées des paramètres d'une loi de distribution de Weibull desdites durées.

**Patentansprüche**

**1.** Testvorrichtung (100) für mindestens eine elektronische Komponente (110), die Folgendes aufweist:

- ein Modul (150), das so konfiguriert ist, dass es eine Spannung (V) im Wesentlichen in Zeitfenstern mit einer Frequenz liefert, die, zumindest vorübergehend, einen oder mehrere Frequenzwerte größer als 10 MHz annimmt;
- mindestens einen Spannungsanlegungsknoten, der dazu bestimmt ist, mit der Komponente verbunden und anschließend von der Komponente getrennt zu werden; und
- einen Detektor (160), der dazu konfiguriert ist, einen Durchbruch eines Dielektrikums der Komponente zu erkennen.

**2.** Vorrichtung nach Anspruch 1, wobei die Frequenz in einem Bereich von 0 bis zu einem vorgegebenen oberen Wert moduliert werden kann, wobei der obere Wert vorzugsweise größer oder gleich 500 MHz ist.

**3.** Vorrichtung nach Anspruch 1 oder 2, die ein Koaxialkabel (222, 230) aufweist, das zum Übertragen der Spannung konfiguriert ist, wobei das Koaxialkabel eine charakteristische Impedanz von vorzugsweise 50 Ω aufweist.

**4.** Vorrichtung nach einem der Ansprüche 1 bis 3, wobei der mindestens eine Knoten mindestens eine Testsonde (120) aufweist, die zum Anlegen der Spannung an die Komponenten (110) konfiguriert ist.

**5.** Vorrichtung nach den Ansprüchen 3 und 4, wobei die Sonde (120) ein Widerstandselement (440) aufweist, dessen Wert im Wesentlichen gleich der charakteristischen Impedanz des Kabels (230), vorzugsweise etwa 50 Ω, ist.

**6.** Vorrichtung nach Anspruch 5, wobei das Widerstandselement (440) mehrere, vorzugsweise vier Widerstände (440A, 440B, 440C, 440D) mit gleichen Werten aufweist, und wobei vorzugsweise:

- die Werte der Widerstände gleich etwa 200 Ω sind; und/oder
- die Widerstände Leistungen gleich etwa 30 mW haben.

**7.** Vorrichtung nach einem der Ansprüche 1 bis 6, die einen Generator (210) für ein Signal (S) aufweist, das abwechselnd ansteigende und abfallende Flanken hat, und einem Tiefpassfilter (220) am Ausgang des Generators, das so konfiguriert ist, dass es die Spannung (V) aus dem Signal liefert.

**8.** Vorrichtung nach Anspruch 7, wobei der Tiefpassfilter eine Dirac-Stufenantwortzeit zwischen 50 ps und 300 ps, vorzugsweise etwa 150 ps, aufweist.

**9.** Vorrichtung nach einem der Ansprüche 1 bis 8, die:

- so konfiguriert ist, dass die Spannung (V) zwischen einem ersten Knoten (120), der mit einer ersten Fläche des Dielektrikums verbunden werden soll, und einem zweiten Knoten (GND) zum Anlegen eines Referenzpotentials angelegt wird; und
- einen Detektor (160; 620, 170) für einen Strom (I) aufweist, der größer als ein Schwellenwert (TH) ist, der den zweiten Knoten mit einem dritten Knoten (122) koppelt, der mit einer zweiten Fläche des Dielektrikums gegenüber der ersten Fläche verbunden werden soll.

**10.** Vorrichtung nach einem der Ansprüche 1 bis 9, wobei die Spannung (V) einen modulierbaren Tastgrad hat.

**11.** Vorrichtung nach einem der Ansprüche 1 bis 10, wobei die Schlitze der Spannung (V) zwischen einem im Wesentlichen Null-Spannungswert und einem vorgegebenen Spannungswert liegen, wobei der vorgegebene Spannungswert vorzugsweise größer als ein maximaler Betriebsspannungswert der Komponente ist.

**12.** Verfahren zum Testen mehrerer elektronischer Bauteile (110), aufweisend Implementieren einer Vorrichtung (100) gemäß den Ansprüchen 1 bis 11.

**13.** Verfahren nach Anspruch 12, das für jeden von mehreren der Frequenzwerte folgende Schritte aufweist:

- für jedes Bauteil nacheinander Anlegen der Spannung an das Bauteil und Messen einer Dauer (tA, tB) des Anlegens der Spannung (V) bis zur Erkennung eines Durchbruchs des Bauteils durch den Detektor (160); und

- Ableiten der Parameter eines Weibull-Verteilungsgesetzes der Dauern aus den Dauern.

**Claims**

1. Test device (100) for at least one electronic component (110), comprising:

   - a module (150) configured to provide a voltage (V) substantially in slots having a frequency taking, at least temporarily, a frequency value(s) greater than 10 MHz;
   - at least one voltage application node, intended to be connected to the component, and then disconnected from the component; and
   - a detector (160) configured to detect a breakdown of a dielectric of the component

2. Device according to claim 1, wherein the frequency can be modulated in a range extending from 0 to a given upper value, the upper value preferably being greater than or equal to 500 MHz.

3. Device according to claim 1 or 2, comprising a coaxial cable (222, 230) configured to transmit said voltage, the coaxial cable having a characteristic impedance, preferably equal to 50 Ω.

4. Device according to any one of claims 1 to 3, wherein said at least one node comprises at least one test probe (120) configured to apply said voltage to said components (110).

5. Device according to claims 3 and 4, wherein the probe (120) comprises a resistive element (440) of value substantially equal to the characteristic impedance of the cable (230), preferably equal to approximately 50 Ω.

6. Device according to claim 5, wherein the resistive element (440) comprises several, preferably four, resistors (440A, 440B, 440C, 440D) of equal values, and, preferably:

   - the values of said resistances are equal to approximately 200 Ω; and/or
   - said resistors have powers equal to approximately 30 mW.

7. Device according to any one of claims 1 to 6, comprising a generator (210) of a signal (S) alternately having rising and falling edges, and a low-pass filter (220) at the output of the generator, configured to supply said voltage (V) from said signal.

8. Device according to claim 7, wherein the low-pass filter has a Dirac step response time of between 50 ps and 300 ps, more preferably equal to approximately 150 ps.

9. Device according to any one of claims 1 to 8:

   - configured so that said voltage (V) is applied between a first node (120) intended to be connected to a first face of the dielectric, and a second node (GND) for applying a reference potential; and
   - comprising a detector (160; 620, 170) of a current (I) greater than a threshold (TH), coupling the second node to a third node (122) intended to be connected to a second face of the dielectric opposite the first face.

10. Device according to any one of claims 1 to 9, wherein said voltage (V) has a duty cycle that can be modulated.

11. Device according to any one of claims 1 to 10, wherein the slots of said voltage (V) are between a substantially zero voltage value and a given voltage value, the given voltage value preferably being greater than a maximum operating voltage value of the component.

12. Method for testing several electronic components (110), comprising implementing a device (100) according to claims 1 to 11.

13. Method according to claim 12, comprising, for each of several of said frequency values, steps of:

   - for each component one after the other, applying said voltage to the component, and measuring a duration (tA, tB) of application of said voltage (V) until detection of a breakdown of the component by the detector (160); and
   - deducing from said durations the parameters of a Weibull distribution law of said durations.

Fig 1

Fig 2

Fig 3

Fig 4

Fig 5

Fig 6

Fig 7

Fig 8

Fig 9

Fig 10A

Fig 10B

Fig 10C

Fig 10D

# EP 3 907 514 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5420513 A

**Littérature non-brevet citée dans la description**

- An agile accelerated aging, characterization and scenario simulation system for gate controlled power transistors. **GREG SONNENFELT et al.** AUTO-TESTCON, 2008. IEEE, 08 September 2008, 208-215
- **E. ROSENBAUM et al.** High-Frequency time-dependent breakdown of SiO/sub 2. *IEEE ELECTRON DEVICE LETTERS*, 30 June 1991, vol. 12 (6)
- Accelerated testing for time dependent dielectric breakdown (TDDB) evaluation of embedded DRAM capacitors using tantalum pentoxide. **INANI et al.** INTERNAT. JOURNAL & WORLD ABSTRACTING SERVICE. ELSEVIER SCIENCE LTD, 20 September 2007, vol. 47
- **ALAN WADSWORTH**. *Fundamentals of Fast Pulsed IV Measurement*, 09 February 2014